Europäisches Patentamt

(19) European Patent Office

Office européen des brevets

(11) Publication number : 0 552 067 A2

## (12) EUROPEAN PATENT APPLICATION

(21) Application number : 93300307.1

(51) Int. Cl.⁵ : H01L 29/808, H01L 29/06

(22) Date of filing : 18.01.93

(30) Priority : 16.01.92 KR 590

(43) Date of publication of application :
21.07.93 Bulletin 93/29

(84) Designated Contracting States :
DE FR GB IT

(71) Applicant : SAMSUNG ELECTRONICS CO.
LTD.
416 Maetan-Dong, Kwonsun-ku
Suwon, Kyunggi-do (KR)

(72) Inventor : Jung, Tae Hwa
1-306 Mirae Villa, 135-2 Chang 1-dong
Tobong-ku, Seoul (KR)
Inventor : Kim, Young Soon
271-207 Jugong Apt., 22 Chamshil 2-dong
Songpa-ku, Seoul (KR)

(74) Representative : Sturt, Clifford Mark et al
J. Miller & Co. 34 Bedford Row Holborn
London WC1R 4JH (GB)

(54) Field effect transistor and a fabricating method thereof.

(57)    The invention provides a field effect transistor comprising ; a substrate (21), source and drain cap layers (25) and an active gate layer (27) characterised by a void (29) located between the cap layers (25) and between the active gate layer (27) and the substrate (21). A method of manufacture is also provided. Preferably, an insulating layer (23) having a predetermined angle against the main crystal orientation of the substrate (21), is used as an epi-mask to form the void (29). The distance between the cap layers is proportional to the width of the insulating layer and thus the effective channel length can be adjusted independent of the length of the gate electrode. Further, the active layer (27) which is used as the channel is separated from the substrate (21) by the void (29). Accordingly, short channel effects due to leakage current can be prevented. In addition, because the short effective channel can be formed by epitaxy independent of the length of the gate electrode, the manufacturing process is simplified.

FIG.2

EP 0 552 067 A2

The present invention relates to a field effect transistor and a fabricating method thereof. The invention is particularly applicable to a junction field effect transistor (hereinafter refer to "JFET") in which the effective channel length is reduced.

With rapid progress towards an information-communication based society, the need for ultrahigh speed computers and ultrahigh frequency and optical communications are becoming more and more important. But, silicon based devices have a limit in satisfying these needs. Thus, research and development on compound semiconductors with superior material properties is becoming progressively more active.

Among the compound semiconductors, GaAs has superior electrical properties such as high electron mobility and semi-insulation. Also, GaAs provides faster operation speeds and smaller power consumption than silicon, thereby being advantageous for military applications and space communications. Accordingly, using GaAs with its superior properties, a variety of devices such as JFETs, metal-semiconductor field effect transistors, heterojunction bipolar transistors, and high electron mobility transistors have been developed.

To take one such device, the JFET is formed with a gate electrode on a gate region and source and drain electrodes on a cap layer. The electrodes are formed of an ohmic metal. The current flowing in the device is controlled by varying the effective channel width using the depletion layer which is formed at the P-N junction interface; by applying a voltage to the gate electrode. As the JFET becomes smaller is size, in accordance with the tendency for high integration, the gate length is also reduced to the submicron regime.

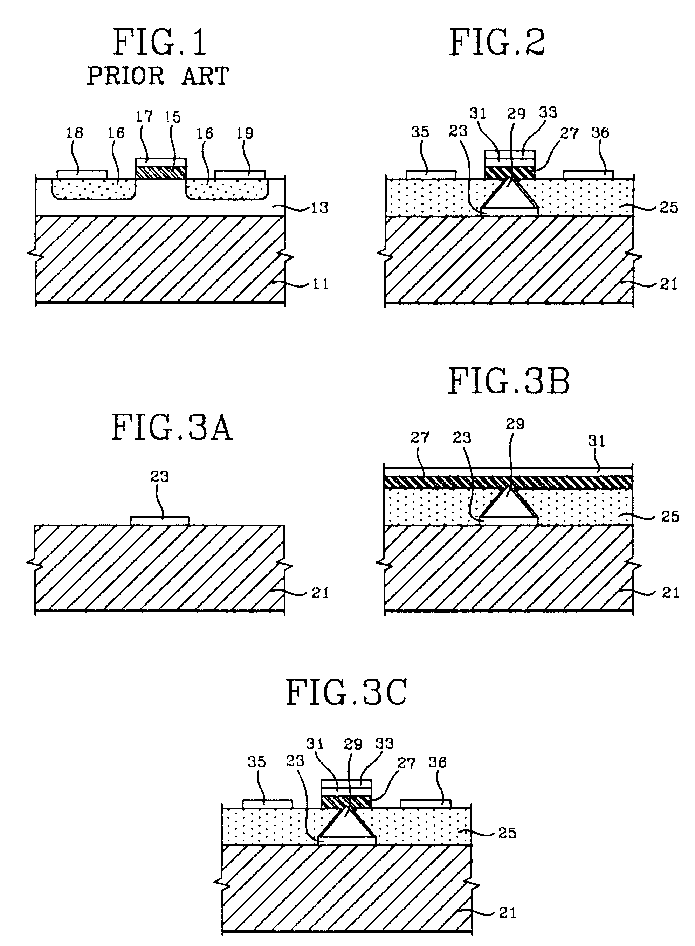

In the prior art JFET, as shown in figure 1, an N-type GaAs active layer 13 is formed on a semi-insulating GaAs substrate 11. A $P^+$-type GaAs gate layer 15 is formed on this active layer 13. In the active layer 13, at both sides of the gate layer 15, are formed $N^+$-type cap regions 16 having a high does of N-type impurities such as Si. A gate electrode 17 is formed on the gate layer 15, and source and drain electrodes 18 and 19 are formed on the cap layers 16, respectively. The gate electrode 17 and the source and drain electrodes 18 and 19 form the ohmic contacts with the gate layer 15 and the cap layers 16. When the JFET is a depletion-mode device; if a negative voltage is applied to the gate 17, the effective channel width between the source and the drain electrodes is varied by the variation of the depletion layer of the p-n junction, thus controlling the current flow.

In the JFET described above, the channel length is defined by the gate electrode. The shorter the gate length, the smaller the source resistance and the larger the transfer gain. The smaller resistance and larger transfer gain are desirable because the noise characteristics are thus improved.

However, because the gate electrode is formed by the photolithography method; there is a difficulty in reducing the effective channel length. Also, if the crystal quality of the layers formed by epitaxy is not good, the current flowing through the active layer is leaked to the semiconductor substrate. This causes the threshold voltage to shift, which results in undesirable short channel effects.

According to a first aspect of the present invention, the is provided a field effect transistor comprising; a substrate, source and drain cap layers and an active gate layer characterised by a void located between the cap layers and between the active gate layer and the substrate

According to a second aspect of the present invention, there is provided a method as claimed in the preceding claim, wherein formation of the cap layers and the active layer are performed simultaneously using metal organic chemical vapour deposition or molecular beam epitaxy.

Thus, the present invention can provide a JFET which has a short effective channel established by a void formed by selective epitaxial growth, independent of the length of a gate electrode.

The present invention can provide a JFET which prevents short channel effects due to the leakage current, by separating a cap layer from a semiconductor substrate using the void.

Further, the present invention can provide a method for fabricating a JFET, that simplifies processing steps by forming a short effective channel length naturally using epitaxy, independent of the length of the gate electrode.

An embodiment of the invention will now be described in detail, by way of example only and with reference to drawings, in which;

Figure 1 is a cross-sectional view of a prior art JFET;

Figure 2 is a cross-sectional view of a JFET which is an embodiment of the present invention, and

Figures 3A to 3C show processing steps for fabricating the JFET shown in figure 2.

With reference to figure 2, an insulating layer 23 of $SiO_z$ or $Si_3N_4$ with a thickness of $500^\sim1000$Å and a width of $1^\sim1.5\mu m$ is formed, in a stripe or rectangular shape, on the surface of a semi-insulating GaAs (100) semiconductor substrate 21. The insulating layer 23 has an angle of $20^\sim30°$ against main orientation $[\bar{1}10]$ of a semi-insulating GaAs that represent the crystal growth direction of the semiconductor substrate 21. $N^+$-type GaAs cap layers 25 of $0.7^\sim1\mu m$ in thickness, whose surfaces are distant from each other by $0.2^\sim0.3\mu m$, are formed on the insulating layer 23. At this time, the insulating layer 23 serves as an epi-mask in forming the cap layers 25. In the cap layers 25, N-type impurities such as Si are highly doped with a dose of $1 \times 10^{18}{}^\sim5 \times 10^{18}$ions/cm$^3$. Also the growth of the cap layers 25 on the insulating layer 23 is limited and the sidewalls thus have an inverse slope.

Subsequently, an N-type active layer 27 with a thickness of 0.3~0.4µm and a dose of 1 x 10¹⁷~5 x 10¹⁷ions/cm³ is formed on the surface of the cap layers 25. The active layer 27 on the inverse slopes of the cap layer 25 becomes thin. The upper surface of the active layer 27 is flat. Because the epitaxial growth does not occur on the insulating layer 23, a triangular void 29 is formed above the insulating layer 23. The height of the void 29 is limited by the width of the insulating layer 23. The void 29 is formed to a height which is higher than the thickness of the cap layers 25; in order to separate the cap layers 25 from each other. The channel is formed in the active layer 27 and the effective channel length can be shortened because the distance between the cap layers 25 is narrow. Also, because the active layer 27 is separated from the semiconductor substrate 21 by the void 29, leakage current is prevented.

A P⁺-type GaAs gate layer 31 is formed on the surface of the active layer 27 to a thickness of 0.2~0.3µm. Layer 31 is doped with P-type impurities such as Cd with a dose of 1 x 10¹⁸~5 x 10¹⁸ions/cm³. Finally, a gate electrode 33 is formed on the surface of the gate layer 31 and source and drain electrodes 35 and 36 are formed on the surfaces of the cap layers 25. The gate electrode 33 is made of AuZn/Au and the source and drain electrodes 35 and 36 are made of AuGe/Ni/Au; thus forming ohmic contacts with the gate layer 31 and the cap layers 25, respectively.

Figure 3 illustrates the processing steps for fabricating the JFET shown in figure 2.

Referring to figure 3A, the insulating layer 23 is formed on the predetermined surface of the semiconductor substrate 21. Referring to figure 3B, N⁺-type GaAs cap layers 25, an N-type GaAs active layer 27, and a P-type GaAs gate layer 31 are formed at one time by crystal growing methods such as MOCVD (metal organic chemical vapour deposition) or MBE (molecular beam epitaxy). The cap layers 25 are formed to a thickness of 0.7~1µm but, importantly, they do not grow on the insulating layer 23. However, as the cap layers grow vertically, horizontal growth also occurs and the cap layers thus progressively project over the insulating layer 23. Thus, the sidewalls of the cap layers 25 form inverse slopes over the insulating layer 23. At their closest, the cap layers are spaced apart from each other by 0.2~0.3µm, above the insulating layer 23. Active layer 27 is formed in a thickness of 0.3~0.4µm but is slightly reduced in thickness at the sidewalls of the cap layers 25. The thin parts of the active layer 27 at the sidewalls meet together, thus forming an upper, flat surface. Hence, when the active layer 27 is formed, a triangular void is sealed above the insulating layer 23. The gate layer 31 is formed in a thickness of 0.2~0.3µm on layer 27.

Referring to figure 3C, after depositing AuZn/Au on the surface of the gate layer 31, a gate electrode 33 is formed above the void 29, using the conventional photolithography method. When the gate electrode 33 has been formed, the gate layer 31 and the active layer 27 are removed at one time (except beneath electrode 33 and layer 27), thus exposing the cap layers 25. Next, source and drain electrodes 35 and 36 are formed of AuGe/Ni on the exposed surfaces of the cap layers 25, using the lift-off method.

In the above described embodiment of the present invention, after forming a stripe type of insulating layer having a predetermined angle against the main orientation of the semiconductor substrate, cap layers with inverse slopes are formed by using the insulating layer as an epi-mask. Also, the cap layers are separated by the void, with the active layer formed on the cap layers. The distance between the cap layers is proportional to the width of the insulating layer and thus the effective channel length can be adjusted independent of the length of the gate electrode. Further the active layer which is used as the channel is separated from the semiconductor substrate by the void.

Accordingly, in the described embodiment of the present invention one can shorten the effective channel length by making the distance between the inverse slopes of the cap layers narrow. The short channel effect, due to leakage current, is prevented by separating the active layer from the semiconductor substrate using the void. In addition, because the short channel device is formed by epitaxy independent of the length of the gate electrode, the process can be simple.

In the above described embodiment of the present invention, the semiconductor substrate is GaAs with an orientation of (001). However, the substrate can have an orientation of (100) or (010) without departing from the concept of the present invention. Also, other compound semiconductor materials such as InP and GaP can be used.

**Claims**

1.  A field effect transistor comprising; a substrate (21), source and drain cap layers (25) and an active gate layer (27) characterised by a void (29) located between the cap layers (25) and between the active gate layer (27) and the substrate (21).

2.  A field effect transistor as claimed in claim 1, further characterised in that an insulating layer (23) is provided on the substrate (21) between the void (29) and the substrate (21).

3.  A field effect transistor as claimed in claim 1, further characterised in that the void (29) has a triangular cross-section with the base thereof adjacent the substrate (21) and the apex thereof adjacent the active gate layer (27).

4. A field effect transistor as claimed in claim 2, further characterised in that the substrate (21) has a predetermined plane of crystal orientation and the insulating layer (23) has a plane of crystal orientation which is off-set with respect to that of the substrate (21).

5. A field effect transistor as claimed in any of claims 1 to 4, further characterised in that the cap layers (25) and the active gate layer (27) are both of a first conductivity type.

6. A field effect transistor as claimed in any preceding claim, further characterised by a highly doped gate layer (31) formed on the surface of the active gate layer (27).

7. A field effect transistor as claimed in claim 6, further characterised in that the highly doped gate layer (31) is formed of a second conductivity type of material.

8. A field effect transistor as claimed in any preceding claim, further characterised in that the substrate (21) is formed of one of GaAs, InP, and GaP.

9. A field effect transistor as claimed in claim 4, further characterised in that the predetermined plane of crystal orientation of the substrate (21) is one of {100}, {010} and {001}.

10. A field effect transistor as claimed in claim 2, further characterised in that the insulating layer (23) is formed of $SiO_2$ or $Si_3N_4$.

11. A field effect transistor as claimed in claim 4, wherein the said off-set is an angle in the range of 20 to 30°.

12. A method of manufacturing a field effect transistor, characterised by the steps of: forming an insulating layer (23) on a surface of a semiconductor substrate (21), forming source and drain cap layers (25) on the surface of the said substrate (21), and forming an active gate layer (27) on the surface of the cap layers (25); such that a void (29) is formed between the cap layers (25) above the insulating layer (23) between the active gate layer (27) and the substrate (21).

13. A method as claimed in the preceding claim, wherein formation of the cap layers (25) and the active layer (27) are performed simultaneously using metal organic chemical vapour deposition or molecular beam epitaxy.

# FIG.1
## PRIOR ART

# FIG.2

# FIG.3A

# FIG.3B

# FIG.3C